# EUROPEAN PATENT APPLICATION

(11) **EP 3 690 961 A1**
(43) Date of publication of application: **05.08.2020**
(21) Application number: 18863702.9
(22) Date of filing: 27.09.2018
(51) Int. Cl.: H01L 31/055, B32B 7/02

(54) **LAMINATED STRUCTURE AND SOLAR POWER GENERATION SYSTEM**

(30) Priority: 29.09.2017 JP 2017192254
(71) Applicant: Sekisui Chemical Co., Ltd., Osaka-shi, Osaka 530-8565 (JP)
(72) Inventor: YOSHIDA, Shougo, Koka-shi, Shiga 528-8585 (JP); OOTA, Yuusuke, Koka-shi, Shiga 528-8585 (JP); IZU, Yasuyuki, 6045 JB Roermond (NL); II, Daizou, Koka-shi, Shiga 528-8585 (JP); MATSUDOU, Masaki, Mishima-gun Osaka 618-0021 (JP); CHOU, Kinryou, Koka-shi, Shiga 528-8585 (JP); NAKAJIMA, Daisuke, Koka-shi, Shiga 528-8585 (JP); NOHARA, Atsushi, Koka-shi, Shiga 528-8585 (JP)
(74) Representative: Ter Meer Steinmeister & Partner
(86) International application number: PCT/JP2018/036139
(87) International publication number: WO 2019/065922

(57) **Abstract**

The laminated structure of the present invention includes a sheet-shaped member and first and second transparent sheets provided on both sides, respectively, of the sheet-shaped member, wherein the sheet-shaped member absorbs excitation light and emits light with wavelength conversion, and has a maximum emission wavelength of 500 nm or more, and a reflectance that is measured for the laminated structure at the maximum emission wavelength is 30% or more.

## Description

### Technical Field

The present invention relates to a laminated structure used for solar power generation or the like in windows and to a solar power system.

### Background Art

Since it is difficult to secure enough space for installing solar panels in a comparatively high construction such as a building, energy creation is not sufficient. Hence, such an approach that solar cells are mounted on windows has been put to practical use. Specifically, a system in which a solar cell module is disposed in an intermediate layer of laminated glass, as an intermediate layer, and a system in which a solar cell module is disposed between plates of glass of double glazing are known. However, the transparency of a solar cell module is generally low, and the solar cell module often impairs visibility. Highly transparent organic solar cells are also in practical use, but have the problem that they don't have sufficient durability.

To address the above problems, disposing power generation cells in the periphery of a window such as a window frame has been studied. For example, a solar radiation conversion device has been developed that contains, in a transparent member such as glass, a wavelength conversion material for converting ultraviolet radiation, visible radiation, or infrared radiation into near infrared radiation, and generates electricity by collecting the light that has been converted by the wavelength conversion material onto a side surface of glass (for example, see PTL 1).

### Citation List

### Patent Document

PTL 1: WO 2015/047084 A1

### Summary of Invention

### Technical Problem

However, in the solar radiation conversion device disclosed in PTL 1, among the light that has been converted into near-infrared light, there exists most of light that is transmitted without being collected onto the side surface, and thus the power generation efficiency is insufficient. Further, when the solar radiation conversion device of PTL 1 is used in a window of a construction, light converted into near-infrared light may enter the room, thereby increasing the temperature of the room.

The present invention has been devised in view of the circumstances described above, and an object thereof is to provide a laminated structure capable of efficiently guiding light that is incident from one surface of the laminated structure and is converted into high-wavelength light such as near-infrared light therein to a side surface.

### Solution to problem

The present inventors has carried out earnest investigation to find that the aforementioned problems can be solved by adjusting, in a laminated structure having a sheet-shaped member that emits light and first and second transparent sheets, the maximum emission wavelength of the sheet-shaped member to a predetermined wavelength or more and the reflectance at the maximum emission wavelength to a predetermined value or more, thereby accomplishing the present invention below. That is, the present invention provides [1] to [11] below.
[1] A laminated structure comprising: a sheet-shaped member; and first and second transparent sheets provided on both sides, respectively, of the sheet-shaped member, wherein the sheet-shaped member absorbs excitation light and emits light with wavelength conversion, and has a maximum emission wavelength of 500 nm or more, and a reflectance of the laminated structure measured at the maximum emission wavelength is 30% or more.
[2] The laminated structure according to [1] above, wherein the sheet-shaped member comprises a wavelength conversion material.
[3] The laminated structure according to [2] above, wherein the sheet-shaped member is a light emitting layer comprising a resin with the wavelength conversion material dispersed in the resin.
[4] The laminated structure according to [2] above, wherein the sheet-shaped member is composed of a coating that is formed on any one surface of the first and second transparent sheets or is constituted by forming a coating on at least one surface of a base film, and the coating comprises a wavelength conversion material.
[5] The laminated structure according to any one of [1] to [4] above, wherein the maximum emission wavelength is 780 to 1300 nm.
[6] The laminated structure according to any one of [1] to [5] above, wherein the sheet-shaped member has a maximum excitation wavelength of 400 nm or less.
[7] The laminated structure according to any one of [1] to [6] above, further comprising: an emission peak reflection layer which reflects at least light having the maximum emission wavelength.
[8] The laminated structure according to [7] above, wherein the emission peak reflection layer is disposed on the opposite side of the surface on which sunlight is incident, relative to the sheet-shaped member.
[9] The laminated structure according to [8] above, wherein the emission peak reflection layer comprises a metal film, and an air layer provided adjacently to the surface of the metal film on the opposite side.
[10] The laminated structure according to any one of [1] to [9] above, wherein a visible light transmittance of the laminated structure is 5% or more.
[11] A solar cell system comprising: the laminated structure according to any one of [1] to [10] above; and a power generation cell disposed at at least one site in the periphery of the laminated structure.

### Advantageous Effects of Invention

The present invention provides a laminated structure capable of efficiently guiding light that is incident from one surface of the laminated structure and is converted into high-wavelength light such as near-infrared light therein to a side surface.

### Brief Description of Drawings

[Fig. 1] Fig. 1 is a schematic sectional view showing a laminated structure according to a first embodiment of the present invention.
[Fig. 2] Fig. 2 is a schematic sectional view showing a laminated structure according to a second embodiment of the present invention.
[Fig. 3] Fig. 3 is a schematic sectional view showing a laminated structure according to a third embodiment of the present invention.
[Fig. 4] Fig. 4 is a schematic sectional view showing a solar cell system according to an embodiment of the present invention.

### Description of Embodiments

Hereinafter, the present invention will be described in detail by referring to embodiments.

### <Laminated structure>

The laminated structure of the present invention is such a structure including: a sheet-shaped member; and first and second transparent sheets provided respectively on both sides, respectively, of the sheet-shaped member, wherein the sheet-shaped member absorbs excitation light and emits light with wavelength conversion, and has a maximum emission wavelength of 500 nm or more. Further, the laminated structure has a reflectance of 30% or more at the aforementioned maximum emission wavelength of the sheet-shaped member.

As the laminated structure of the present invention has such a configuration, the laminated structure enables at least part of light such as sunlight incident on one surface of the laminated structure, after being converted into comparatively long-wavelength light by the sheet-shaped member, to be reflected inside the laminated structure and guided to a side surface of the laminated structure. Since such light with long-wavelength can be generally converted into electricity with high efficiency by using power generation cells, the power generation efficiency in the power generation cell can be enhanced by disposing a power generation cell in the periphery of the laminated structure.

As will be described below, the laminated structure is used for windows of various constructions, vehicles, and the like, and in such a case, one surface of the laminated structure is disposed on the outdoor side, and sunlight is incident from the one surface of the laminated structure. In this description, the one surface of the laminated structure means a surface of the laminated structure orthogonal to the layer direction of the laminated structure, and the other surface of the laminated structure means the surface on the opposite side of the one surface. Further, in the case when such notations as a surface on one side of each layer (such as the sheet-shaped member) and a surface on the other side are used in the description, they respectively mean the surfaces of the layer disposed on one side and on the other side of the laminated structure.

If the sheet-shaped member has a maximum emission wavelength of less than 500 nm, the sheet-shaped member cannot sufficiently emit long-wavelength light, and the power generation cell cannot generate power with high power generation efficiency. The maximum emission wavelength of the sheet-shaped member is preferably 700 nm or more, more preferably 780 nm or more. When the maximum emission wavelength is adjusted to such a lower limit or more, the light emitted by the sheet-shaped member is near-infrared light, and thereby it enables the power generation efficiency in the power generation cell to be further enhanced. Further, even if the reflectance at the maximum emission wavelength is as high as described above, the visible light transmittance of the laminated structure is less likely to decrease.

The maximum emission wavelength in the sheet-shaped member is preferably 1400 nm or less, more preferably 1300 nm or less, to achieve wavelength conversion and emission of light by a typical wavelength conversion material, although the upper limit thereof is not limited to a particular value.

Further, the maximum excitation wavelength of the sheet-shaped member is preferably 400 nm or less. In this way, when the maximum excitation wavelength falls within the UV region, the emission efficiency in the sheet-shaped member can be enhanced without significantly reducing the visible light transmittance of the laminated structure. Further, since the UV transmittance of the laminated structure is reduced, UV radiation inside constructions, vehicles, and the like can be decreased. In view of such points, the maximum excitation wavelength is more preferably 390 nm or less. The maximum excitation wavelength is generally 200 nm or more, preferably 300 nm or more, although the lower limit value thereof is not limited to a particular value.

Further, when the reflectance at the maximum emission wavelength of the laminated structure is less than 30%, most of light emitted by the sheet-shaped member is not reflected by the laminated structure. Therefore, light converted into high-wavelength light by the sheet-shaped member cannot be efficiently guided to the side surface of the laminated structure, and the power generation efficiency in the power generation cell, for example, provided in the periphery decreases. Further, a comparatively large amount of long-wavelength light such as near-infrared light is emitted from the other surface of the laminated structure, therefore easily increasing the internal temperature of vehicles, constructions, and the like.

The reflectance is preferably 40% or more, more preferably 50% or more. When the reflectance is adjusted to such a lower limit or more, the amount of long-wavelength light such as near-infrared light to be emitted from the other surface can be reduced, and the power generation efficiency in the power generation cell can be enhanced. Further, the reflectance is preferably 90% or less, more preferably 80% or less, for ensuring the visible light transmission of the laminated structure. The reflectance means a reflectance to be measured when one surface of the laminated structure is irradiated with light at 45 degrees.

The laminated structure of the present invention preferably has a visible light transmittance of 5% or more. When the visible light transmittance is 5% or more, the laminated structure transmits a certain amount of light. Thereby, the laminated structure transmits part of light such as sunlight incident on one surface to emit it from the other surface and therefore can be used as a transparent window.

For enhancing the transparency of the laminated structure, the visible light transmittance is more preferably 30% or more, further preferably 60% or more. Further, the upper limit of the visible light transmittance is not specifically limited, but is preferably 95% or less, more preferably 89% or less. The visible light transmittance means an average of visible light transmittances at 400 to 780 nm.

The laminated structure of the present invention preferably further includes an emission peak reflection layer which reflects at least light having the maximum emission wavelength. The reflectance at the maximum emission wavelength can be enhanced by the laminated structure having the emission peak reflection layer, as described above.

In such a case, the emission peak reflection layer is preferably disposed on the other surface (that is, the surface opposite to the surface on which sunlight is incident) side, relative to the sheet-shaped member in the laminated structure. That is, in the laminated structure, the sheet-shaped member is disposed on one surface side on which sunlight is incident, relative to the emission peak reflection layer. Such a configuration allows sunlight to be incident on the sheet-shaped member before being reflected by the emission peak reflection layer, and thus the sheet-shaped member can effectively absorb excitation light such as ultraviolet light comprised in sunlight to emit light. Further, the emission of the sheet-shaped member can be appropriately reflected by the emission peak reflection layer inside the laminated structure, therefore facilitating guiding the emission of the sheet-shaped member to the side surface of the laminated structure.

Next, each member of the laminated structure will be described in detail.

### [Sheet-shaped member]

The sheet-shaped member of the present invention preferably contains a wavelength conversion material.

As the wavelength conversion material, a material that converts light on the short wavelength side into light on the high wavelength side, specifically, into light having a maximum emission wavelength of 500 nm or more may be used. Specific examples include barium stannate (BaSnO₃), mixed crystals containing ytterbium and cerium, mixed crystals containing praseodymium and ytterbium, mixed crystals containing bismuth and ytterbium, and compounds containing lanthanoid ions such as europium ions and thulium ions. The compounds containing lanthanoid ions are preferably complex compounds such as europium complexes. Further, barium stannate may be doped with metal ions such as iron and zinc. Further, YSO (Y₂SiO₅) doped with ytterbium and cerium (YSO:Ce,Yb) may be used as the wavelength conversion material.

The wavelength conversion material preferably converts the wavelength of ultraviolet light so as to have a maximum emission wavelength of near-infrared light, and is particularly preferably barium stannate. Likewise, YSO:Ce,Yb is also preferable.

Further, the wavelength conversion material is preferably used in the particle form, and the average particle size thereof is, for example, 10 to 400 nm, preferably 10 to 200 nm, more preferably 10 to 100 nm. The average particle size thereof can be measured by a nanoparticle analyzer (nano Partica SZ-100, manufactured by HORIBA, Ltd). The average particle size of the wavelength conversion material is measured according to the following procedure. First, the wavelength conversion material is dispersed in methanol to a concentration of 5 wt%, to obtain a measurement sample. Using the nanoparticle analyzer (nano Partica SZ-100), D50 of the aforementioned measurement sample is measured as the average particle size.

In the present invention, the sheet-shaped member containing such a wavelength conversion material is interposed between two transparent sheets, and therefore its deterioration is effectively suppressed.

The sheet-shaped member is preferably composed of a light emitting layer containing a resin, in which the wavelength conversion material is dispersed, and a thermoplastic resin is preferably used as the resin. Use of a thermoplastic resin makes it easy for the sheet-shaped member to exert functions as an adhesive layer and facilitates bonding the sheet-shaped member to the first and second transparent sheets or the like.

In the case where the wavelength conversion material is dispersed in the resin, the content of the wavelength conversion material is preferably 0.01 to 3 parts by mass, more preferably 0.05 to 1.5 parts by mass, further preferably 0.1 to 1.0 part by mass, based on 100 parts by mass of resins.

Adjusting the content of the wavelength conversion material to such a lower limit or more enables the sheet-shaped member to sufficiently emit light. Further, adjusting it to such an upper limit or less can prevent the visible light transmittance from decreasing more than necessary.

In the case where the sheet-shaped member is composed of a light emitting layer comprising the wavelength conversion material that is dispersed in a resin, the thickness is, for example, 0.1 to 2.0 mm, preferably 0.2 to 1.0 mm.

Further, the sheet-shaped member may be a coating that is formed on at least any one of the surfaces of the first and second transparent members. The coating has the wavelength conversion material and may be formed by vacuum vapor deposition, sputtering, coating or the like of the wavelength conversion material.

The sheet-shaped member may be disposed between the first and second transparent members also in the case of being a coating formed on any one of the surfaces of the first and second transparent members. Accordingly, the sheet-shaped member composed of a coating may be formed on at least any one of the surface on the other side of the first transparent sheet and the surface on the one side of the second transparent sheet. In such a case, the first and second transparent sheets on at least one of which a coating is formed may be bonded to each other via an interlayer. Further, the sheet-shaped member composed of a coating is preferably formed on the surface on the other side of the first transparent sheet.

Further, the sheet-shaped member may be constituted by forming a coating on one surface of a base film such as a resin film that is provided separately from the first and second transparent sheets. Such a coating includes a wavelength conversion material and may be formed on the base film by vacuum vapor deposition, sputtering, coating, or the like of the wavelength conversion material.

The base film (the sheet-shaped member) having such a coating formed on one surface as above may be disposed so as to be interposed between two interlayers. Likewise, also in the case where the sheet-shaped member is composed of a light emitting layer containing a resin with the wavelength conversion material dispersed in the resin, the light emitting layer may be disposed so as to be interposed between two interlayers. Such a pair of interlayers between which the sheet-shaped member disposed may be further disposed so as to be interposed between the first and second transparent sheets.

Further, a known resin such as polyester may be used as a resin employed in the base film. The thickness of the base film is, for example, 1 mm or less, preferably about 10 to 400 µm.

The coating having the wavelength conversion material may consist of the wavelength conversion material or may contain binder components or the like in addition to the wavelength conversion material or the like.

Further, the thickness of the coating having the wavelength conversion material is, for example, 1 to 50 nm, preferably 3 to 25 nm. Further, each interlayer has a thickness of, for example, 0.1 to 2.0 mm, preferably 0.2 to 1.0 mm. The interlayer is a layer containing a resin, and a thermoplastic resin is preferably used as the resin.

The thermoplastic resin used for the sheet-shaped member and the interlayers is not specifically limited, but examples thereof include a polyvinyl acetal resin, an ethylene-vinyl acetate copolymer resin, an ionomer resin, a polyurethane resin, and a thermoplastic elastomer. Use of such a resin facilitates ensuring adhesion to the first and second transparent sheets or the like. In each of the sheet-shaped member and the interlayer, one of the thermoplastic resins may be used alone, or two or more of them may be used in combination. Among these, a polyvinyl acetal resin is particularly suitable, for exerting excellent adhesion to glass, in the case where each of the sheet-shaped member and the interlayer contains a plasticizer.

### (Polyvinyl acetal resin)

The polyvinyl acetal resin is not specifically limited as long as the polyvinyl acetal resin is obtained by acetalization of polyvinyl alcohol with aldehyde, but is suitably a polyvinyl butyral resin.

The lower limit of the degree of acetalization of the aforementioned polyvinyl acetal resin is preferably 40 mol%, the upper limit is preferably 85 mol%, the lower limit is more preferably 60 mol%, and the upper limit is more preferably 75 mol%.

The lower limit of the amount of hydroxyl groups in the polyvinyl acetal resin is preferably 15 mol%, and the upper limit is preferably 35 mol%. Adjusting the amount of hydroxyl groups to 15 mol% or more facilitates achieving good adhesion to the first and second transparent sheets, particularly, good adhesion thereto in the case when the first and second transparent sheets are inorganic glass, and facilitates achieving good penetration resistance or the like of the laminated structure. Further, adjusting the amount of hydroxyl groups to 35 mol% or less prevents the laminated structure from becoming excessively hard. The lower limit of the amount of hydroxyl groups is more preferably 25 mol%, and the upper limit is more preferably 33 mol%.

Also in the case of using a polyvinyl butyral resin as the polyvinyl acetal resin, the lower limit of the amount of hydroxyl groups is preferably 15 mol%, the upper limit is preferably 35 mol%, the lower limit is more preferably 25 mol%, and the upper limit is more preferably 33 mol%, from the same point of view.

The degree of acetalization and the amount of hydroxyl groups can be measured, for example, by a method according to JIS K6728 "Testing methods for polyvinyl butyral".

The polyvinyl acetal resin can be prepared by acetalization of polyvinyl alcohol with aldehyde. Polyvinyl alcohol is typically obtained by saponification of polyvinyl acetate, and polyvinyl alcohol with a saponification degree of 80 to 99.8 mol% is generally used therefor.

The lower limit of the degree of polymerization of the polyvinyl acetal resin is preferably 500, and the upper limit is preferably 4000. Adjusting the degree of polymerization to 500 or more allows the laminated structure to have good penetration resistance. Further, adjusting the degree of polymerization to 4000 or less facilitates forming the laminated structure. The lower limit of the degree of polymerization is more preferably 1000, and the upper limit is more preferably 3600.

The aldehyde is not specifically limited, but an aldehyde having 1 to 10 carbon atoms is generally suitably used therefor. The aldehyde having 1 to 10 carbon atoms is not specifically limited, and examples thereof include n-butyraldehyde, isobutyraldehyde, n-valeraldehyde, 2-ethylbutyraldehyde, n-hexylaldehyde, n-octylaldehyde, n-nonylaldehyde, n-decylaldehyde, formaldehyde, acetaldehyde, and benzaldehyde. Among these, n-butyraldehyde, n-hexylaldehyde, and n-valeraldehyde are preferable, and n-butyraldehyde is more preferable. These aldehydes may be used singly, or in combinations of two or more.

### (Ethylene-vinyl acetate copolymer resin)

The ethylene-vinyl acetate copolymer resin may be an uncrosslinked ethylene-vinyl acetate copolymer resin, or may be a high-temperature crosslinkable ethylene-vinyl acetate copolymer resin. Further, an ethylene-vinyl acetate modified resin such as a saponified product of ethylene-vinyl acetate copolymer and a hydrolysate of ethylene-vinyl acetate can also be used as the ethylene-vinyl acetate copolymer resin.

The ethylene-vinyl acetate copolymer resin has a vinyl acetate content, as measured according to JIS K6730 "Testing methods for ethylene-vinyl acetate resin", of preferably 10 to 50 mass%, more preferably 20 to 40 mass%. Adjusting the vinyl acetate content to such a lower limit or more facilitates achieving good adhesion to the first and second transparent sheets or the like and good penetration resistance of the laminated structure. Further, adjusting the vinyl acetate content to such an upper limit or less enhances the fracture strength of the sheet-shaped member or the interlayer, and allows the laminated structure to have good impact resistance.

### (Ionomer resin)

The ionomer resin is not specifically limited, and various ionomer resins can be used therefor. Specifically, examples thereof include ethylene-based ionomers, styrene-based ionomers, perfluorocarbon-based ionomers, telechelic ionomers, and polyurethane ionomers. Among these, ethylene-based ionomers are preferable, for allowing the laminated structure to have good mechanical strength, good durability, good transparency, and the like, and in the case when the first and second transparent sheets are inorganic glass, for achieving excellent adhesion thereto.

As such an ethylene-based ionomer, an ionomer of ethylene-unsaturated carboxylic acid copolymer is suitably used because of its excellent transparency and toughness. The ethylene-unsaturated carboxylic acid copolymer is a copolymer at least having constitutional units derived from ethylene and constitutional units derived from unsaturated carboxylic acid, and optionally having constitutional units derived from other monomers.

Examples of the unsaturated carboxylic acid include acrylic acid, methacrylic acid, and maleic acid. Acrylic acid and methacrylic acid are preferable. Further, examples of the other monomers include acrylic acid ester, methacrylic acid ester, and 1-butene.

As for the ethylene-unsaturated carboxylic acid copolymer, in the case when all constitutional units contained in the copolymer is defined as 100 mol%, the copolymer preferably has 75 to 99 mol% of constitutional units derived from ethylene and preferably has 1 to 25 mol% of constitutional units derived from unsaturated carboxylic acid.

The ionomer of ethylene-unsaturated carboxylic acid copolymer is an ionomer resin obtained by neutralizing or crosslinking at least part of carboxyl groups contained in the ethylene-unsaturated carboxylic acid copolymer with metal ions, and the degree of neutralization of the carboxyl groups is typically 1 to 90%, preferably 5 to 85%.

Examples of ion sources contained in the ionomer resin include alkali metals such as lithium, sodium, potassium, rubidium, and cesium, and polyvalent metals such as magnesium, calcium, and zinc. Sodium and zinc are preferable.

The method for producing such an ionomer resin is not specifically limited, and a conventionally known production method can be used for the production. For example, in the case where an ionomer of ethylene-unsaturated carboxylic acid copolymer is used as the ionomer resin, ethylene and unsaturated carboxylic acid are radically copolymerized under a high temperature and high pressure, to produce an ethylene-unsaturated carboxylic acid copolymer. Then, the ethylene-unsaturated carboxylic acid copolymer is reacted with a metal compound containing the aforementioned ion source, so that the ionomer of ethylene-unsaturated carboxylic acid copolymer can be produced.

### (Polyurethane resin)

Examples of the polyurethane resin include polyurethane obtained by reacting an isocyanate compound with a diol compound, and polyurethane obtained by reacting an isocyanate compound with a diol compound and further a chain extender such as polyamine. Further, the polyurethane resin may contain sulfur atoms. In such a case, part or whole of the aforementioned diol may be selected from the group consisting of polythiols and sulfur-containing polyols. The polyurethane resin can improve adhesion to the first and second transparent sheets composed of resin plates or the like. Therefore, the polyurethane resin is suitably used in the case where at least one of the first and second transparent sheets is a resin plate.

### (Thermoplastic elastomer)

Examples of the thermoplastic elastomer include styrene-based thermoplastic elastomers and aliphatic polyolefins.

The styrene-based thermoplastic elastomers are not specifically limited, and known elastomers can be used. Styrene-based thermoplastic elastomers generally have a styrene monomer-polymer block serving as the hard segment and a conjugated diene compound-polymer block or a hydrogenated block thereof serving as the soft segment. Specific examples of the styrene-based thermoplastic elastomers include a styrene-isoprene diblock copolymer, a styrene-butadiene diblock copolymer, a styrene-isoprene-styrene triblock copolymer, a styrene-butadiene/isoprene-styrene triblock copolymer, a styrene-butadiene-styrene triblock copolymer, and hydrogenated products thereof.

The aliphatic polyolefins may be saturated aliphatic polyolefins or may be unsaturated aliphatic polyolefins. The aliphatic polyolefins may be polyolefins containing chain olefins as monomers or may be polyolefins containing cyclic olefins as monomers. For effectively enhancing the storage stability and the sound insulating properties of the interlayer, the aliphatic polyolefins are preferably saturated aliphatic polyolefins.

Examples of materials for the aliphatic polyolefins include ethylene, propylene, 1-butene, trans-2-butene, cis-2-butene, 1-pentene, trans-2-pentene, cis-2-pentene, 1-hexene, trans-2-hexene, cis-2-hexene, trans-3-hexene, cis-3-hexene, 1-heptene, trans-2-heptene, cis-2-heptene, trans-3-heptene, cis-3-heptene, 1-octene, trans-2-octene, cis-2-octene, trans-3-octene, cis-3-octene, trans-4-octene, cis-4-octene, 1-nonene, trans-2-nonene, cis-2-nonene, trans-3-nonene, cis-3-nonene, trans-4-nonene, cis-4-nonene, 1-decene, trans-2-decene, cis-2-decene, trans-3-decene, cis-3-decene, trans-4-decene, cis-4-decene, trans-5-decene, cis-5-decene, 4-methyl-1-pentene, and vinyl cyclohexane.

### (Plasticizer)

In the case where the sheet-shaped member or the interlayer comprises a thermoplastic resin, the sheet-shaped member or the interlayer may further comprise a plasticizer. When the sheet-shaped member or the interlayer comprises a plasticizer, the sheet-shaped member or the interlayer is flexible, as a result of which the laminated structure is flexible. Further, particularly, in the case where the first and second transparent sheets are inorganic glass plates, adhesion to these sheets can be enhanced. In the case where a polyvinyl acetal resin is used as the thermoplastic resin, the inclusion of a plasticizer in the layer is particularly effective.

Examples of the plasticizer include triethylene glycol di-2-ethylbutyrate, triethylene glycol di-2-ethyl hexanoate, triethylene glycol dicaprylate, triethylene glycol di-n-octanoate, triethylene glycol di-n-heptanoate, tetraethylene glycol din-heptanoate, tetraethylene glycol di-2-ethyl hexanoate, dibutyl sebacate, dioctyl azelate, dibutyl carbitol adipate, ethylene glycol di-2-ethylbutyrate, 1,3-propylene glycol di-2-ethylbutyrate, 1,4-butylene glycol di-2-ethylbutyrate, 1,2-butylene glycol di-2-ethylbutyrate, diethylene glycol di-2-ethylbutyrate, diethylene glycol di-2-ethylhexanoate, dipropylene glycol di-2-ethylbutyrate, triethylene glycol di-2-ethylpentanoate, tetraethylene glycol di-2-ethylbutyrate, diethylene glycol dicaprylate, triethylene glycol di-n-heptanoate, tetraethylene glycol di-n-heptanoate, triethylene glycol di-2-ethylbutyrate, dihexyl adipate, dioctyl adipate, hexylcyclohexyl adipate, diisononyl adipate, heptylnonyl adipate, dibutyl sebacate, oil-modified sebacic alkyds, a mixture of a phosphate ester and an adipate ester, adipate esters, mixed adipate esters fabricated from an alkyl alcohol having 4 to 9 carbon atoms and a cyclic alcohol having 4 to 9 carbon atoms, and adipate esters having 6 to 8 carbon atoms such as hexyl adipate. Among these plasticizers, triethylene glycol-di-2-ethyl hexanoate (3GO) is particularly suitably used.

In the sheet-shaped member or the interlayer, the content of plasticizer is not specifically limited, but the lower limit is preferably 30 parts by mass, and the upper limit is preferably 70 parts by mass, relative to 100 parts by mass of the thermoplastic resin. When the content of plasticizer is 30 parts by mass or more, the laminated structure becomes appropriately flexible, and its handleability and the like is improved. Further, when the content of plasticizer is 70 parts by mass or less, separation of the plasticizer from the sheet-shaped member or the interlayer is prevented. The lower limit of the content of plasticizer is more preferably 35 parts by mass, and the upper limit is more preferably 63 parts by mass.

Further, in the case when thermoplastic resin is comprised in the sheet-shaped member or the interlayer of the present invention, the thermoplastic resin, or the thermoplastic resin and the plasticizer is comprised as the main component therein. The total amount of the thermoplastic resin and the plasticizer is typically 70 mass% or more, preferably 80 mass% or more, further preferably 90 mass% or more, based on the total amount of the sheet-shaped member or the interlayer.

### (Other additives)

The transparent sheet-shaped member may contain additives such as antioxidants, adhesion modifiers, pigments, dyes, ultraviolet absorbers, and infrared absorbers, as needed. Among these, antioxidants are preferably used.

The antioxidants are not specifically limited, and examples thereof include 2,2-bis[[[3-(3,5-di-tert-butyl-4-hydroxyphenyl)propionyl]oxy]methyl]propane-1,3-diol 1,3-bis[3-(3,5-di-tert-butyl-4-hydroxyphenyl) propionate], 4,4'-thiobis(6-tert-butyl-3-methylphenol), 4,4'-dimethyl-6,6'-di(tert-butyl)[2,2'-methylenebis(phenol)], 2,6-di-t-butyl-p-cresol, and 4,4'-butylidenebis-(6-t-butyl-3-methylphenol).

### [First and second transparent sheets]

Any sheet that can be used as the first and second transparent sheets without specific limitation, as long as it can be used for windows, and specific examples thereof include inorganic glass plates and resin plates. The inorganic glass plates are not specifically limited, but examples thereof include clear glass, float plate glass, polished plate glass, figured glass, net-wired plate glass, line-wired plate glass, and green glass.

Further, resin plates, generally called resin glass, are used therefor and are not specifically limited, but examples thereof include transparent resin plates composed of polycarbonates, acrylic resins, acrylic copolymer resins, polyesters or the like.

Further, a glass transition temperature of the resin plate is preferably 100°C or more. When the glass transition temperature is 100°C or more, sufficient strength can be ensured in the case when a resin plate is used as the first and second transparent sheets.

Further, the glass transition temperature of the resin plate is more preferably 110°C or more and preferably 300°C or less, more preferably 200°C or less. Examples of the method for measuring the glass transition temperature include differential scanning calorimetry (DSC) according to JIS K7121 or the like.

The first and second transparent sheets may be composed of the same material as each other or may be composed of different materials. For example, the first transparent sheet may be an inorganic glass plate, and the second transparent sheet may be a resin plate. However, it is preferable that both of the first and second transparent sheets be inorganic glass plates, or both be resin plates.

The visible light transmittance of each of the first and second transparent sheets is favorably as high as possible, but is practically 20% or more, preferably 60% or more. Further, the visible light transmittance of each of the first and second transparent sheets may be 100% or less, practically 99% or less. The visible light transmittance of each of the first and second transparent sheets may be the same or may be different.

Further, the thickness of each of the first and second transparent sheets is not specifically limited but is, for example, about 0.1 to 15 mm, preferably 0.5 to 5 mm. The thickness of each of the first and second transparent sheets may be the same or may be different.

### [Emission peak reflection layer]

The emission peak reflection layer used in the present invention is a layer which reflects at least light having the maximum emission wavelength, specifically, a layer configured to allow the reflectance of the laminated structure at the maximum emission wavelength to be 30% or more. Further, the emission peak reflection layer preferably has a visible light transmittance higher than the transmittance at the maximum emission wavelength, while selectively reflecting light having the maximum emission wavelength and in the vicinity of the wavelength. This facilitates adjusting the visible light transmittance of the laminated structure to the aforementioned desired range.

Examples of the emission peak reflection layer include a metal film that is formed on a surface of the second transparent sheet or the like. The metal film may be formed on the surface on the one side of the second transparent sheet or may be formed on the surface on the other side thereof.

Further, reflection films that are conventionally used as heat reflecting films, infrared reflecting films, or the like may also be employed. Specifically, examples thereof include a reflection film in which a metal film is formed on at least one surface of a base film that is composed of a resin film or the like. Further, examples thereof include a reflection film having a structure in which alternately low-refractive index layers with relatively low refractive indices and high-refractive index layers with relatively high refractive indices are arranged into multiple layers, and a reflection film comprising infrared absorbing particles that are dispersed in a resin film. Such a reflection film is bonded, for example, to a surface of the second transparent sheet or the like. The reflection film may be bonded to the surface on the one side of the second transparent sheet or may be bonded to the surface on the other side thereof. The reflection film may be bonded to the second transparent sheet by pressure bonding or the like or may be bonded to the second transparent sheet using an adhesive or an interlayer or the like.

Examples of metals used for the metal film include gold, silver, copper, indium, titanium, zirconium, indium, or metal oxides of these. Among them, silver is preferable. In the case of using a metal film, a multi-layer structure in which different types of metals or metal oxides are laminated into multiple layers may be employed. Both the reflectance in the near-infrared region and the visible light transmittance can be enhanced, for example, by aging the metal film at 200°C or more after sputtering.

Further, in the case of using the metal film, the thickness of the metal film is preferably 5 to 1000 nm, more preferably 7 to 50 nm, for achieving both good reflectance in the near-infrared region and good visible light transmittance. In the case when the emission peak reflection layer has a plurality of layers of metal film, the thickness of the metal film means the total thickness thereof.

Further, in the case where the metal film is formed on the second transparent sheet or the like, the metal film can be formed by coating with each metal by sputtering, electroless plating, vacuum evaporation, ion plating, or the like, and sputtering is preferably used therefor.

Among the aforementioned examples, a metal film or a reflection film having a structure in which alternately low-refractive index layers and high-refractive index layers are arranged into multiple layers is preferably used as the emission peak reflection layer. Among those metal films, a metal film that is formed on a surface of the second transparent sheet is particularly preferable.

The metal film may consist only of metals, but may comprise binder components or the like in addition to such metals, as long as functions as an emission peak reflection layer are not impaired.

The emission peak reflection layer is preferably disposed on the other surface side, relative to the sheet-shaped member, as described above. For example, the emission peak reflection layer can be disposed on the other surface side, relative to the sheet-shaped member, by being formed or bonded to a surface of the second transparent sheet, as described above.

Further, for example, in the case where the sheet-shaped member is formed on the surface on the other side of the first transparent sheet, the emission peak reflection layer composed of a reflection film and the like may be disposed between the first and second transparent sheets, so as to be interposed between two interlayers.

Further, the surface on the other side of the emission peak reflection layer may be adjacent to an air layer, and it is particularly preferable that the metal film be adjacent to the air layer. Having a large difference in refractive index from the emission peak reflection layer, particularly, the metal film, the air layer provided adjacently can enhance the reflectance of the emission peak reflection layer. Accordingly, in the case of being adjacent to the air layer, the emission peak reflection layer is preferably formed on the surface on the other side of the second transparent sheet, particularly preferably, the metal film is formed thereon.

Further, the laminated structure may further includes a third transparent sheet, and in such case, the third transparent sheet may be disposed at a certain distance or more from the surface on the other side of the emission peak reflection layer, thereby providing an air layer between the emission peak reflection layer and the third transparent sheet.

The laminated structure having the third transparent sheet as above is generally called double glazing, and the peripheral portions of the first to third transparent sheets, for example, are fixed to a frame such as a window frame. According to such an embodiment, the third transparent sheet can be disposed on the other surface side, relative to the second transparent sheet, via the air layer.

Since the metal film is covered by the third transparent sheet even in the case where the metal film is disposed in contact with the air layer, the laminated structure having the third transparent sheet can prevent damage by the metal film to members provided in the periphery of the laminated structure.

In the case where the third transparent sheet is provided on the other surface side of the emission peak reflection layer via the air layer, as described above, the spacing distance between the third transparent sheet and the emission peak reflection layer (that is, the thickness of the air layer) is, for example, 1 to 50 mm, preferably 5 to 35 mm.

Similarly to the first and second transparent sheets, materials that can be used for windows may be used as the third transparent sheet, and specific examples of the third transparent sheet include inorganic glass plates and resin plates. The details of such inorganic glass plates and resin plates are as described above.

### (Layer configuration)

The laminated structure of the present invention includes the sheet-shaped member and the first and second transparent sheets, as described above. Further, the laminated structure of the present invention preferably includes the emission peak reflection layer. Hereinafter, layer configurations according to preferable aspects of the laminated structure of the present invention will be described in detail as the first to third embodiments with reference to the drawings.

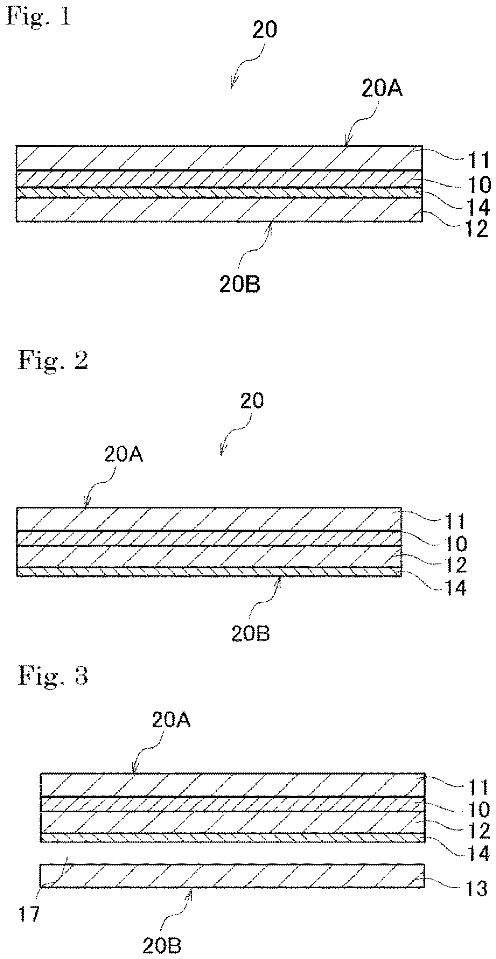

A laminated structure 20 according to the first embodiment includes first and second transparent sheets 11 and 12 which are provided respectively on both sides, separately, of a sheet-shaped member 10, and light such as sunlight is incident from the first transparent sheet 11 side (that is, one surface 20A of the laminated structure 20). Further, the laminated structure 20 includes an emission peak reflection layer 14 that is disposed on the other surface 20B side, relative to the sheet-shaped member 10. Here, as shown in Fig. 1, the emission peak reflection layer 14 is provided between the sheet-shaped member 10 and the second transparent sheet 12.

The emission peak reflection layer 14 that is provided between the sheet-shaped member 10 and the second transparent sheet 12 is composed of a metal film and is preferably coated onto the second transparent sheet 12, but a reflection film or the like other than the metal film may be used instead of the metal film.

Further, a light emitting layer comprising the wavelength conversion material dispersed in a resin may be used as the sheet-shaped member 10. Then, the first transparent sheet 11 and the second transparent sheet 12, on which the emission peak reflection layer 14 composed of a coating or the like formed, may be bonded together by the sheet-shaped member (light emitting layer) 10.

In the same manner as in the first embodiment, the laminated structure 20 according to the second embodiment includes the sheet-shaped member 10 and the first and second transparent sheets 11 and 12 which are provided respectively on both sides, respectively, of the sheet-shaped member 10, and light such as sunlight is incident from the first transparent sheet 11 side (that is, the one surface 20A). In the laminated structure 20 of this embodiment, the emission peak reflection layer 14 is provided on the surface on the other surface 20B side of the second transparent sheet 12. That is, the emission peak reflection layer 14 is disposed on the other surface 20B side, relative to the sheet-shaped member 10, further, the second transparent sheet 12.

In the second embodiment, the emission peak reflection layer 14 may be a metal film that is formed on a surface of the second transparent sheet 12, or other materials may be used. However, it is better not to provide the metal film on the surface on the other surface 20B side of the emission peak reflection layer 14. Accordingly, various reflection films are preferably used as the emission peak reflection layer 14, and a reflection film having a structure with low-refractive index layers and high-refractive index layers alternately provided in multiple layers is more preferably used, for example. Damage to other members or the like due to the metal film being exposed is prevented by not using the metal film on the surface on the other surface 20B side of the emission peak reflection layer 14.

Further, also in the second embodiment, a light emitting layer comprising the wavelength conversion material dispersed in a resin is preferably used as the sheet-shaped member 10, and the light emitting layer bonds the first and second transparent sheets 11 and 12 together.

The laminated structure 20 according to the third embodiment is further provided with a third transparent sheet 13, compared to the laminated structure according to the second embodiment. Here, the third transparent sheet 13 is disposed on the other surface side of the emission peak reflection layer 14 at a certain distance spaced from the emission peak reflection layer 14, thereby providing an air layer 17 between the emission peak reflection layer 14 and the third transparent sheet 13. In the third embodiment, the emission peak reflection layer 14 is preferably a metal film that is formed on a surface of the second transparent sheet 12, but other materials such as reflection films may be used. In this embodiment, even if the emission peak reflection layer 14 is a metal film, damage to other members or the like by the laminated structure is prevented by providing the third transparent sheet 13.

The layer configurations of the laminated structure are, of course, not limited to the configurations shown in Fig. 1 to Fig. 3, and the laminated structure may have any other layer configuration. For example, in the case where the sheet-shaped member 10 is composed of a coating having a wavelength conversion material, as described above, an interlayer may be provided.

Further, layers other than the first to third transparent sheets, the sheet-shaped member, the emission peak reflection layer, and the interlayer may be provided. For example, in the case where the emission peak reflection layer has a low adhesion to the second transparent sheet or the like, an adhesive layer may be provided between the emission peak reflection layer and the second transparent sheet or the like.

### [Method for producing laminated structure]

The laminated structure of the present invention is not specifically limited, but, for example, in the case where the sheet-shaped member contains a resin, a laminated structure having a first transparent sheet, a sheet-shaped member, and a second transparent sheet can be obtained by disposing at least the sheet-shaped member between two transparent sheets and integrating them by thermocompression bonding or the like.

Further, in the case where the sheet-shaped member is a coating including a wavelength conversion material, a laminated structure can be obtained by forming the sheet-shaped member composed of a coating on at least one surface of the first and second transparent sheets, thereafter disposing an interlayer between the first and second transparent sheets, and integrating them by thermocompression bonding or the like.

Further, in the case where the sheet-shaped member is constituted by forming a coating on one surface of a base film, a laminated structure may be obtained by disposing two interlayers with a sheet-shaped member interposed therebetween so as to be further interposed between the first and second transparent sheets and integrating them by thermocompression bonding or the like.

In the case of providing the emission peak reflection layer, a metal film may be coated onto a surface of the second transparent sheet or the like to form an emission peak reflection layer, or a reflection film may be appropriately bonded to the second transparent sheet or the like, so that the reflection film serves as an emission peak reflection layer. In such a case, the emission peak reflection layer may be formed before or after the first transparent sheet, the sheet-shaped member, and the second transparent sheet are integrated.

Further, in the case of providing the third transparent sheet, a laminate having the first transparent sheet, the sheet-shaped member, and the second transparent sheet may be obtained, and the laminate and the third transparent sheet may be thereafter fixed to a frame or the like.

### [Uses of laminated structure]

The laminated structure of the present invention is used with one surface of the laminated structure disposed on the outdoor side on which sunlight is incident, as described above. The laminated structure of the present invention can be used in various fields but is preferably used for outdoor windows of various vehicles such as automobiles, trains, and ships, various constructions such as buildings, apartments, stand-alone houses, halls, and gymnasiums, and the like. Outdoor windows in this description mean windows disposed at positions on which sunlight is incident. Accordingly, outdoor windows are generally disposed on the outer sides of constructions or the outer sides of vehicles, but outdoor windows in this description also include inner windows of double windows as long as they are disposed at positions on which sunlight is incident.

Further, the laminated structure may be used for rear windows, side windows, or roof windows in automobiles.

### <Solar cell system>

The solar cell system of the present invention includes: the aforementioned laminated structure; and a power generation cell disposed at at least one site in the periphery of the laminated structure and configured to convert incident light into electricity. The power generation cell may be disposed so as to be able to receive light reflected inside the laminated structure and guided toward a side surface of the laminated structure.

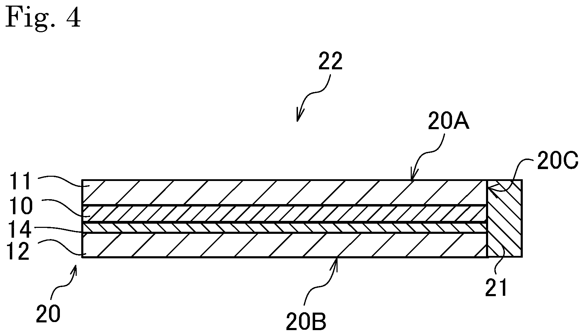

Fig. 4 shows an example of a solar cell system 22 including the laminated structure 20 and a power generation cell 21. The power generation cell 21 is typically disposed on the outer side of a side surface 20C of the laminated structure 20. In such a case, as shown in Fig. 4, the power generation cell 21 may be disposed in contact with the side surface 20C of the laminated structure 20 or may be provided apart from the side surface 20C of the laminated structure 20 so as to be opposed to the side surface 20C. However, the power generation cell 21 is not necessarily provided on the outer side of the side surface 20C, and may be embedded in the laminated structure 20, for example, in the periphery of the laminated structure 20.

Further, as shown in Fig. 4, the power generation cell 21 may be disposed throughout the thickness direction of the laminated structure 20 so as to be able to receive light propagated inside the laminated structure 20 or may be disposed in part of the thickness direction so as to be able to receive light propagated inside the laminated structure 20. However, the power generation cell 21 is preferably disposed so as to be able to receive at least light emitted from layers disposed on the one surface 20A side (that is, the sunlight incident side), relative to the emission peak reflection layer 14. This is because the power generation efficiency can be enhanced, since light having the maximum emission wavelength or in the vicinity of the maximum emission wavelength is more propagated in a portion on the one surface 20A side, relative to the emission peak reflection layer 14.

### [Power generation cell]

The power generation cell used in the solar cell system is not specifically limited, as long as it is a cell that converts light into electricity. However, the power generation cell preferably converts light at the maximum emission wavelength of the sheet-shaped member or in the vicinity thereof into electricity with high efficiency. Accordingly, the power generation efficiency of the power generation cell may be highest at any wavelength of 500 nm or more, preferably 700 to 1400 nm, more preferably 780 to 1300 nm. Such a high power generation efficiency for light in the near-infrared region can enhance the power generation efficiency in the case when the maximum emission wavelength of the sheet-shaped member is in the near-infrared region.

Specific examples of the power generation cell include power generation cells in which silicon-based semiconductor such as single crystal silicon, polycrystalline silicon, and amorphous silicon is used as photoelectric conversion layer thereof, power generation cells in which a compound semiconductor typified by CuInSe-based, Cu(In,Ga)Se-based, Ag(In,Ga)Se-based, CuInS-based, Cu(In,Ga)S-based, Ag(In,Ga)S-based compounds, solid solutions thereof, and CIS-based, CIGS-based, GaAs-based, and CdTe-based compounds is used as photoelectric conversion layer thereof, and organic power generation cells in which organic materials such as organic pigments is used as photoelectric conversion layer thereof.

To enhance the power generation efficiency from light in the near infrared region, a power generation cell in which a silicon semiconductor or a compound semiconductor (CIS or CIGS) is used for a photoelectric conversion layer thereof is preferable.

### Examples

The present invention will be described in more detail by referring to examples, but the present invention is by no means limited by these Examples.

The methods for measuring the maximum emission wavelength, the maximum excitation wavelength, the reflectance, and the visible light transmittance, and the method for evaluating the laminated structure are as follows.

### [Maximum excitation wavelength and maximum emission wavelength]

The maximum excitation wavelength is a wavelength of excitation light at which the fluorescence intensity detected under the condition of the maximum emission wavelength reaches a maximum, when the surface on one side of a sheet-shaped member is perpendicularly irradiated with excitation light at 300 to 500 nm by using a device Fluorolog-3 manufactured by HORIBA, Ltd. The maximum emission wavelength is a wavelength at which the emission intensity detected under the condition of 500 to 1400 nm reaches a maximum, when the surface on the one side of the sheet-shaped member is perpendicularly irradiated with light having the maximum excitation wavelength.

### [Reflectance]

The reflectance was measured according to JISR3212 except for the angle, using an ultraviolet-visible-infrared spectrophotometer U4150 (manufactured by Hitachi High-Technologies Corporation), by installing the laminated structure so that light is incident on one surface thereof at 45 degrees, and the reflectance at the maximum emission wavelength was determined. Accordingly, the reflectance at 840 nm was determined in Examples 1 to 8 and Comparative Example 1. The reflectance at 980 nm was determined in Example 9.

### [Visible light transmittance]

The visible light transmittance was measured by an ultraviolet-visible-infrared spectrophotometer U4150 (manufactured by Hitachi High-Technologies Corporation) according to JIS R3212, and an average of visible light transmittances at 400 to 780 nm was determined.

### (Evaluation of amount of light)

When pseudo sunlight was incident from one surface (a surface of the first transparent sheet) side of the laminated structure obtained in each of Examples and Comparative Example, the amount of light emitted from the side surface of the laminated structure was measured and evaluated according to the following evaluation criteria. As a light source of pseudo sunlight, a solar simulator HAL-C100, available from Asahi Spectra Co., Ltd. was used. A light intensity checker, available from Asahi Spectra Co., Ltd. was used for measuring the amount of light.
A: Amount of light increased 1.2 times, compared to that of Comparative Example 1.
B: Amount of light increased, as compared with that of Comparative Example 1 only by less than 1.2 times.
C: Amount of light is the same as or less than that of Comparative Example 1.

Compounds used for the sheet-shaped member of each of Examples and Comparative Example were as follows.
Polyvinyl butyral resin (PVB): a degree of acetalization of 69 mol%, an amount of hydroxyl groups of 30 mol%, and a degree of polymerization of 1700 Ethylene-vinyl acetate copolymer resin (EVA): a vinyl acetate content of 30 mass%
Thermoplastic elastomer: aliphatic polyolefin "ABSORTOMER EP-1001" available from Mitsui Chemicals, Inc.
Wavelength conversion material:
BaSnO₃ barium stannate, particulate, average particle size 50 µm
YSO:Ce,Yb, particulate, average particle size: 50 µm
Plasticizer: triethylene glycol di-2-ethyl hexanoate (3GO)
Antioxidant: 2,6-di-t-butyl-p-cresol (BHT)
Paraffin oil: "Diana Process Oil PW-90", available from Idemitsu Kosan Co., Ltd. Adhesion modifier: "ARUFON UH-2041", available from TOAGOSEI CO., LTD. UV screening agent: 2-(2-hydroxy-3-t-butyl-5-methylphenyl)-5-chlorobenzotriazole

### [Example 1]

Three sheets of clear glass (with a thickness of 2.5 mm and a visible light transmittance of 90%) were prepared as the first to third transparent sheets, and a metal film (an emission peak reflection layer with a thickness of 10 nm) composed of silver was formed on one surface of one sheet of the clear glass by sputtering.

Further, 0.2 parts by mass of a wavelength conversion material (BaSnO₃), 40 parts by mass of a plasticizer, and 0.2 parts by mass of an antioxidant were mixed with 100 parts by mass of polyvinyl butyral resin (PVB), followed by extrusion molding of the mixture using a twin-screw anisotropic extruder, to obtain a sheet-shaped member with a thickness of 0.76 mm. The maximum excitation wavelength and the maximum emission wavelength of the sheet-shaped member were as shown in Table 1.

Thereafter, the sheet-shaped member and another sheet of the clear glass were stacked in this order on the opposite side of the surface of the clear glass, of which on the other side of the surface, the metal film was formed, followed by preheating in an oven at a temperature of 240°C for 90 seconds, and then were subjected to temporarily pressure-bonding by using a heating roll. The temporarily pressure-bonded structure was pressure-bonded under conditions of 150°C and a pressure of 1.2 MPa for 30 minutes by using an autoclave, so as to obtain a laminate composed of such a layered structure of first transparent sheet/sheet-shaped member/second transparent sheet/emission peak reflection layer. Further, the laminate and the third transparent sheet were fixed with a frame so that the third transparent sheet was disposed at a distance of 10 mm apart from the emission peak reflection layer of the laminate, to obtain a laminated structure according to the third embodiment, which is composed of first transparent sheet/sheet-shaped member/second transparent sheet/emission peak reflection layer/air layer/third transparent sheet.

### [Example 2]

The same procedure was performed in the same manner as in Example 1, except that 0.2 parts by mass of a wavelength conversion material and 0.2 parts by mass of an antioxidant were mixed with 100 parts by mass of ethylene-vinyl acetate copolymer resin (EVA), followed by extrusion molding of the mixture using a twin-screw anisotropic extruder, to obtain a sheet-shaped member with a thickness of 0.76 mm.

### [Example 3]

100 parts by mass of a thermoplastic elastomer, 40 parts by mass of a paraffin oil, 5 parts by mass of an adhesion modifier, 0.2 parts by mass of a wavelength conversion material, a UV screening agent in an amount of 0.2 mass% in the interlayer to be obtained, and an antioxidant in an amount of 0.2 mass% in the interlayer to be obtained were kneaded together and were extruded using an extruder. The same procedure was performed in the same manner as in Example 1, except that a single-layer sheet-shaped member (thermoplastic elastomer sheet with a thickness of 800 µm) was thereby prepared.

### [Example 4]

Two sheets of green glass (with a thickness of 2.0 mm and a visible light transmittance of 84%) were prepared as the first and second transparent sheets, and a metal film (an emission peak reflection layer with a thickness of 10 nm) composed of silver was formed on one surface of one sheet of the green glass by sputtering. Further, a sheet-shaped member with a thickness of 0.76 mm was obtained in the similar manner to that of Example 1.

Thereafter, the sheet-shaped member and the other clear glass were stacked in this order on the surface, on which the metal film was formed, of the green glass with the metal film formed thereon, followed by temporary pressure bonding and pressure bonding under the same conditions as in Example 1, to obtain a laminated structure according to the first embodiment, which is composed of first transparent sheet/sheet-shaped member/emission peak reflection layer/second transparent sheet.

### [Example 5]

Two sheets of clear glass (with a thickness of 2.5 mm and a visible light transmittance of 90%) were prepared as the first and second transparent sheets. Further, a sheet-shaped member was obtained in the same manner as in Example 1.

Thereafter, the sheet-shaped member and the other clear glass were stacked in this order on a surface of one of the clear glass, followed by temporary pressure bonding and pressure bonding under the same conditions as in Example 1, to obtain a laminate composed of first transparent sheet/sheet-shaped member/second transparent sheet. Further, a heat reflection film (product name "Refleshine TZ33", available from Sumitomo Riko Company Limited, with a thickness of 94 µm) was bonded onto the outer surface of the second transparent sheet of the laminate, to obtain a laminated structure according to the second embodiment, which is composed of first transparent sheet/sheet-shaped member/second transparent sheet/emission peak reflection layer. The heat reflection film was a reflection film having a structure composed of low-refractive index layers and high-refractive index layers alternately provided in multiple layers.

### [Example 6]

The same procedure was performed in the same manner as in Example 4, except that clear glass with a thickness of 2.5 mm and a visible light transmittance of 90% was used as the first and second transparent sheets, instead of green glass.

### [Example 7]

Transparent resin plates composed of polycarbonate with a thickness of 3.0 mm and a visible light transmittance of 90% were used as the first and second transparent sheets. Further, the same procedure was performed in the same manner as in Example 5, except that 0.2 parts by mass of a wavelength conversion material and 0.2 parts by mass of an antioxidant were mixed with 100 parts by mass of ethylene-vinyl acetate copolymer resin (EVA), followed by extrusion molding of the mixture using a twin-screw anisotropic extruder, to obtain a sheet-shaped member with a thickness of 0.76 mm.

### [Example 8]

The same procedure was performed in the same manner as in Example 1, except that a metal film (an emission peak reflection layer with a thickness of 10 nm) composed of gold was formed on one surface of one sheet of the clear glass by sputtering, instead of the metal film composed of silver.

### [Example 9]

The same procedure was performed in the same manner as in Example 1, except that YSO:Cₑ,Yb was used as a wavelength conversion material, in place of BaSnO₃.

### [Comparative Example 1]

Two sheets of clear glass (with a thickness of 2.5 mm and a visible light transmittance of 90%) were prepared as the first and second transparent sheets. Further, a sheet-shaped member with a thickness of 0.76 mm was obtained in the same manner as in Example 1.

Thereafter, the sheet-shaped member and the other clear glass were stacked in this order on a surface of one of the clear glass, followed by temporary pressure bonding and pressure bonding in the same manner as in Example 1, to obtain a laminated structure composed of first transparent sheet/sheet-shaped member/second transparent sheet.

Tables 1 and 2 below show the conditions for each of Examples and Comparative Example, and the reflectance, the visible light transmittance, and the results of evaluating the amount of light emitted of the laminated structure obtained. The reflectance is a reflectance at the maximum emission wavelength of the sheet-shaped member.

**Table 1**

| | | Example 1 | Example 2 | Example 3 | Example 4 | Example 5 |
|---|---|---|---|---|---|---|
| First transparent sheet | Type | Clear glass | Clear glass | Clear glass | Green glass | Clear glass |
| | Thickness | 2.5 mm | 2.5 mm | 2.5 mm | 2.0 mm | 2.5 mm |
| Second transparent sheet | Type | Clear glass | Clear glass | Clear glass | Green glass | Clear glass |
| | Thickness | 2.5 mm | 2.5 mm | 2.5 mm | 2.0 mm | 2.5 mm |
| Sheet-shaped member | Type | PVB | EVA | Thermoplastic elastomer | PVB | PVB |
| | Wavelength conversion material | BaSnO₃ | BaSnO₃ | BaSnO₃ | BaSnO₃ | BaSnO₃ |
| | Excitation wavelength peak (nm) | 380 | 380 | 380 | 380 | 380 |
| | Emission wavelength peak (nm) | 840 | 840 | 840 | 840 | 840 |
| Emission peak reflection layer | Type | Silver sputtering | Silver sputtering | Silver sputtering | Silver sputtering | Heat reflecting film |
| | Thickness | 10 nm | 10 nm | 10 nm | 10 nm | 94 µm) |
| Laminated structure | Layer configuration | Third embodiment | Third embodiment | Third embodiment | First embodiment | Second embodiment |
| | Reflectance | 30 | 30 | 30 | 31 | 60 |
| | Visible light transmittance (%) | 79 | 79 | 79 | 73 | 75 |
| | Evaluation of amount of light | A | A | A | B | A |

**Table 2**

| | | Example 6 | Example 7 | Example 8 | Example 9 | Comparative Example 1 |
|---|---|---|---|---|---|---|
| First transparent sheet | Type | Clear glass | Polycarbonate | Clear glass | Clear glass | Clear glass |
| | Thickness | 2.5 mm | 3mm | 2.5 mm | 2.5 mm | 2.5 mm |
| Second transparent sheet | Type | Clear glass | Polycarbonate | Clear glass | Clear glass | Clear glass |
| | Thickness | 2.5 mm | 3mm | 2.5 mm | 2.5 mm | 2.5 mm |
| Sheet-shaped member | Type | PVB | EVA | PVB | PVB | PVB |
| | Wavelength conversion material | BaSnO₃ | BaSnO₃ | BaSnO₃ | YSO: Ce, Vb | BaSnO₃ |
| | Excitation wavelength peak (nm) | 380 | 380 | 380 | 360 | 380 |
| | Emission wavelength peak (nm) | 840 | 840 | 840 | 980 | 840 |
| Emission peak reflection layer | Type | Silver sputtering | Heat reflecting film | Gold sputtering | Silver sputtering | None |
| | Thickness | 10 nm | 94 µm) | 10 nm | 10 nm | - |
| Laminated structure | Layer configuration | First embodiment | Second embodiment | Third embodiment | Third embodiment | |
| | Reflectance | 30 | 60 | 30 | 30 | 5 |
| | Visible light transmittance (%) | 77 | 77 | 79 | 79 | 85 |
| | Evaluation of amount of light | A | A | B | A | - |

As shown in Tables 1 and 2, light on the short wavelength side that had been converted into light on the long wavelength side such as near-infrared light could be efficiently guided to a side surface of the laminated structure in each Example by providing the sheet-shaped member including the wavelength conversion material and the emission peak reflection layer. Further, the laminated structures of Examples 1 to 8 each had a high visible light transmittance, and therefore, use as a highly transparent window is possible.

### Reference Signs List

- 10:: Sheet-shaped member
- 11:: First transparent sheet
- 12:: Second transparent sheet
- 13:: Third transparent sheet
- 14:: Emission peak reflection layer
- 17:: Air layer
- 20:: Laminated structure
- 20A:: One surface
- 20B:: The other surface
- 20C:: Side surface
- 21:: Power generation cell
- 22:: Solar cell system

## Claims

1. A laminated structure comprising: a sheet-shaped member; and first and second transparent sheets provided on both surfaces, respectively, of the sheet-shaped member, wherein
the sheet-shaped member absorbs excitation light and emits light with wavelength conversion, and has a maximum emission wavelength of 500 nm or more, and
a reflectance of the laminated structure at the maximum emission wavelength is 30% or more.

2. The laminated structure according to claim 1, wherein the sheet-shaped member comprises a wavelength conversion material.

3. The laminated structure according to claim 2, wherein the sheet-shaped member is a light emitting layer comprising a resin and the wavelength conversion material dispersed in the resin.

4. The laminated structure according to claim 2, wherein
the sheet-shaped member is composed of a coating that is formed on any one surface of the first and second transparent sheets or is constituted by forming a coating on at least one surface of a base film, and
the coating comprises a wavelength conversion material.

5. The laminated structure according to any one of claims 1 to 4, wherein the maximum emission wavelength is 780 to 1300 nm.

6. The laminated structure according to any one of claims 1 to 5, wherein the sheet-shaped member has a maximum excitation wavelength of 400 nm or less.

7. The laminated structure according to any one of claims 1 to 6, further comprising an emission peak reflection layer which reflects at least light having the maximum emission wavelength.

8. The laminated structure according to claim 7, wherein the emission peak reflection layer is disposed on the opposite side of the surface on which sunlight is incident, relative to the sheet-shaped member.

9. The laminated structure according to claim 8, wherein the emission peak reflection layer comprises a metal film, and an air layer provided adjacently to the surface of the metal film on the opposite side.

10. The laminated structure according to any one of claims 1 to 9, wherein a visible light transmittance of the laminated structure is 5% or more.

11. A solar cell system comprising: the laminated structure according to any one of claims 1 to 10; and a power generation cell disposed at at least one site in the periphery of the laminated structure.
